# EUROPEAN PATENT APPLICATION

(11) **EP 4 685 923 A1**
(43) Date of publication of application: **28.01.2026**
(21) Application number: 24795675.8
(22) Date of filing: 14.03.2024
(51) Int. Cl.: H01M 10/613, H01M 10/627

(54) **DOOR-MOUNTED LIQUID COOLING UNIT AND ENERGY STORAGE CABINET HAVING DOOR-MOUNTED LIQUID COOLING UNIT**

(30) Priority: 27.04.2023 CN 202310481372
(71) Applicant: Huawei Digital Power Technologies Co., Ltd., Shenzhen, Guangdong 518043 (CN)
(72) Inventor: DU, Chenghua, Shenzhen, Guangdong 518043 (CN); LI, Malin, Shenzhen, Guangdong 518043 (CN); LIU, Huan, Shenzhen, Guangdong 518043 (CN)
(74) Representative: Isarpatent
(86) International application number: PCT/CN2024/081688
(87) International publication number: WO 2024/222292

(57) **Abstract**

This application relates to the field of refrigeration unit technologies, and in particular, to a door-mounted liquid cooling unit and an energy storage cabinet with a door-mounted liquid cooling unit. The energy storage cabinet includes an energy storage cabinet and the liquid cooling unit, the energy storage cabinet is configured to accommodate the liquid cooling unit and at least one of a battery pack or a power converter, the energy storage cabinet includes a cabinet body and a cabinet door, the cabinet door is configured to close the cabinet body, the cabinet body is configured to fasten at least one of the battery pack or the power converter, and the liquid cooling unit is fastened to a side that is of the cabinet door and that faces the battery pack or the power converter. In this application, the liquid cooling unit in the energy storage cabinet with the door-mounted liquid cooling unit is fastened to the cabinet door of the energy storage cabinet, to reduce space occupied by the liquid cooling unit in the cabinet body of the energy storage cabinet, and improve space utilization of the energy storage cabinet.

## Description

### CROSS-REFERENCE TO RELATED APPLICATIONS

This application claims priority to Chinese Patent Application No. 202310481372.X, filed with the China National Intellectual Property Administration on April 27, 2023 and entitled "DOOR-MOUNTED LIQUID COOLING UNIT AND ENERGY STORAGE CABINET WITH DOOR-MOUNTED LIQUID COOLING UNIT", which is incorporated herein by reference in its entirety.

### TECHNICAL FIELD

This application relates to the field of refrigeration unit technologies, and in particular, to a door-mounted liquid cooling unit and an energy storage cabinet with a door-mounted liquid cooling unit.

### BACKGROUND

With rapid development of an energy storage industry, an energy storage battery is also widely used. In a process of charging and discharging the energy storage battery, a large amount of heat is generated, so that temperatures of the energy storage battery and a power converter connected to the energy storage battery continuously increase. When an ambient temperature around the battery rises to a specific temperature, a reaction speed in the battery is increased, a life of the battery is shortened, and there is a risk of catching fire or explosion. An excessively high temperature of the power converter causes a life reduction of the power converter.

Therefore, for the energy storage battery and the power converter, a liquid cooling unit needs to be disposed in an energy storage system including the energy storage battery and the power converter, and the liquid cooling unit dissipates heat for the energy storage battery and the power converter. However, the liquid cooling unit occupies some space of the energy storage system, resulting in low space utilization of the energy storage system.

### SUMMARY

This application provides a door-mounted liquid cooling unit and an energy storage cabinet with a door-mounted liquid cooling unit. The liquid cooling unit in the door-mounted liquid cooling unit is fastened to a cabinet door of the energy storage cabinet, to reduce space occupied by the liquid cooling unit in a cabinet body of the energy storage cabinet, and improve space utilization of the energy storage cabinet.

According to a first aspect, this application provides an energy storage cabinet with a door-mounted liquid cooling unit. The energy storage cabinet with the door-mounted liquid cooling unit includes the liquid cooling unit, the energy storage cabinet is configured to accommodate the liquid cooling unit and at least one of a battery pack or a power converter, the energy storage cabinet includes a cabinet body and a cabinet door, the cabinet door is configured to close the cabinet body, the cabinet body is configured to fasten at least one of the battery pack or the power converter, and the liquid cooling unit is fastened to a side that is of the cabinet door and that faces the battery pack or the power converter. Specifically, the liquid cooling unit is fastened to the cabinet door, and independent space for mounting the liquid cooling unit does not need to be disposed in the cabinet body, so that the liquid cooling unit occupies small space of the cabinet body, thereby improving space utilization of the cabinet body.

In an embodiment, the liquid cooling unit includes an internal circulation compartment and an external circulation compartment, the internal circulation compartment and the external circulation compartment are separated from each other, the internal circulation compartment is stacked on the external circulation compartment in a height direction of the cabinet body, in other words, the internal circulation compartment is located above the external circulation compartment, the internal circulation compartment communicates with the cabinet body, and the external circulation compartment communicates with an outside of the energy storage cabinet. The internal circulation compartment and the external circulation compartment are separated from each other so that components in the liquid cooling unit are disposed in different regions for ease of maintenance. In addition, external air is prevented from entering an inside of the cabinet body, improving stability of the battery pack or the power converter in the cabinet body.

In an embodiment, the cabinet body is connected to the cabinet door in a width direction of the cabinet body by using a hinge structure, the internal circulation compartment includes a liquid cooling terminal interface group, the liquid cooling terminal interface group is arranged on a side that is of the internal circulation compartment and that faces the hinge structure, the liquid cooling terminal interface group is configured to communicate with at least one liquid cooling pipeline group, and the at least one liquid cooling pipeline group is configured to dissipate heat for the battery pack or the power converter. The liquid cooling pipeline group is connected to the liquid cooling terminal interface group in a quick-plug manner, so that the battery pack or the power converter is conveniently connected to the liquid cooling unit, and convenience of connecting the battery pack or the power converter to the liquid cooling unit is improved.

In an embodiment, the internal circulation compartment is configured to accommodate an electronic control apparatus, a valve body assembly, a compressor, a condensation plate heat exchanger, and a dehumidification module, the electronic control apparatus is electrically connected to the compressor, the valve body assembly, and the dehumidification module, the valve body assembly further communicates with the liquid cooling terminal interface group, the compressor, the condensation plate heat exchanger, and the dehumidification module separately, and the condensation plate heat exchanger is configured to provide a cold source for the dehumidification module. In this manner, the dehumidification module can dehumidify air in the cabinet body, the condensation plate heat exchanger provides the cold source for the dehumidification module, and an independent cold source for serving the dehumidification module is not needed. This simplifies a structure of the liquid cooling unit, and can further reduce costs of the liquid cooling unit.

It should be noted that the internal circulation compartment is further configured to accommodate the evaporation plate heat exchanger, the first water pump, and the second water pump, and the evaporation plate heat exchanger, the first water pump, and the second water pump all communicate with the valve body assembly.

In an embodiment, the compressor and the electronic control apparatus are disposed at an interval in a height direction of the cabinet door, the compressor and the condensation plate heat exchanger are disposed at an interval in a width direction of the cabinet door, the dehumidification module is disposed between the compressor and the condensation plate heat exchanger, the valve body assembly and the condensation plate heat exchanger are disposed at an interval in a direction perpendicular to the height direction of the cabinet body and the width direction of the cabinet body, the compressor is disposed at a bottom of the internal circulation compartment, the electronic control apparatus is disposed at a top of the internal circulation compartment, and the compressor and the electronic control apparatus are located on a left side of the internal circulation compartment in the width direction of the cabinet body.

More specifically, the internal circulation compartment further includes a first maintenance window and a second maintenance window, the first maintenance window and the second maintenance window are disposed at an interval in the height direction of the cabinet door, and the first maintenance window and the second maintenance window are disposed on a left side of the cabinet door in the width direction of the cabinet door. In this disposition manner, the first maintenance window corresponds to the electronic control apparatus, and the second maintenance window corresponds to the compressor, to facilitate maintenance of the electronic control apparatus and the compressor.

In an embodiment, the external circulation compartment is configured to accommodate an outdoor heat exchanger and at least one heat exchange fan and the outdoor heat exchanger is configured to exchange heat with the outside of the energy storage cabinet. The air outside the energy storage cabinet enters the external circulation compartment passing through the outdoor heat exchanger, and flows out of the external circulation compartment through the heat exchange fan. The outdoor heat exchanger communicates with the valve body assembly. A quantity of heat exchange fans is disposed according to an actual requirement.

When a temperature of the battery pack or a temperature of the power converter or temperatures of the battery pack and the power converter is excessively high, a high-temperature refrigerant in the battery pack or a high-temperature refrigerant in the power converter or high-temperature refrigerants in the battery pack and power converter communicates with the liquid cooling terminal interface group through the liquid cooling pipeline group, and then communicates with the valve body assembly, the evaporation plate heat exchanger, the condensation plate heat exchanger, the compressor, the dehumidification module, the first water pump, and the second water pump, to reduce temperatures of the high-temperature refrigerants, and reduce the temperatures of the battery pack and the power converter. The outdoor heat exchanger exchanges heat with the air outside the energy storage cabinet, and transports a low-temperature refrigerant to the valve body assembly. When air humidity in the energy storage cabinet is excessively high, a dehumidification apparatus sucks the air in the energy storage cabinet into the internal circulation compartment, dehumidifies the sucked air, and exhausts dehumidified air from the internal circulation compartment back to the energy storage cabinet, to dehumidify the energy storage cabinet, thereby improving working stability of the energy storage battery and the power module.

When the heat exchange fan and the outdoor heat exchanger are specifically disposed, the heat exchange fan is disposed above the outdoor heat exchanger in the height direction of the cabinet door. In addition, to ensure that the air flowing through the heat exchange fan to the outside of the external circulation compartment does not flow back, and prevent a large-granularity impurity from entering the outdoor heat exchanger, the liquid cooling unit further includes an air guide shutter and a filter screen. Both the air guide shutter and the filter screen are detachably mounted in the external circulation compartment. The air guide shutter corresponds to at least one heat exchange fan, and the filter screen corresponds to the outdoor heat exchanger.

In an embodiment, the liquid cooling unit includes a main frame, a first cover plate, a second cover plate, and a partition plate, the main frame is mounted on the cabinet door, the main frame includes a first side plate, a second side plate, a third side plate, and a fourth side plate that are sequentially connected head to tail, one end of the partition plate is connected to the first side plate and the other end of the partition plate is connected to the third side plate in the width direction of the cabinet door, the first cover plate is located on a side that is of the main frame and that faces the cabinet body, the first cover plate covers the side that is of the main frame and that faces the cabinet body, the second cover plate is located on a side that is of the main frame and that faces the cabinet door, and the second cover plate covers a part between the partition plate and the second side plate. Specifically, in the width direction of the cabinet body, the first side plate is disposed on a left side, and the foregoing liquid cooling terminal interface group is disposed on the third side plate. In addition, the partition plate, the first cover plate, the first side plate, the third side plate, and the fourth side plate form the external circulation compartment. The partition plate, the first cover plate, the second cover plate, the first side plate, the second side plate, and the third side plate form the internal circulation compartment.

It should be noted that the first side plate is provided with a first opening and a second opening, the first opening and the second opening are located between the partition plate and the second side plate, the first opening is provided on a side that is of the first side plate and that is close to the second side plate, so that the first opening corresponds to the electronic control apparatus, and the second opening is provided on a side that is of the first side plate and that is close to the partition plate, so that the second opening corresponds to the compressor.

In an embodiment, a mounting opening is disposed on a side that is of the cabinet door and that is away from the cabinet body, the liquid cooling unit is mounted on the mounting opening, and a protective net is mounted on the mounting opening. This facilitates mounting of the liquid cooling unit on the cabinet door, and prevents an impurity from entering the external circulation compartment.

In an embodiment, the cabinet body includes the battery pack and the power converter, and the battery pack is located above the power converter in the height direction of the cabinet body. In some other embodiments, the power converter is located above the battery pack in the height direction of the cabinet body.

In an embodiment, when the cabinet door closes the cabinet body, the liquid cooling unit partially overlaps the cabinet body in a projection of a plane that is perpendicular to the height direction of the cabinet body. In this way, when the cabinet door is closed, a part of the liquid cooling unit is located in the cabinet body. Compared with that the liquid cooling unit is completely disposed in the cabinet body, or an independent chamber is disposed in the cabinet body to mount the liquid cooling unit, space occupied by the liquid cooling unit in the cabinet body can be reduced.

According to a second aspect, this application further provides a door-mounted liquid cooling unit. The liquid cooling unit includes a main frame, an internal circulation compartment, and an external circulation compartment, the internal circulation compartment and the external circulation compartment are disposed on the main frame, the internal circulation compartment and the external circulation compartment are separated from each other, the internal circulation compartment is configured to accommodate a liquid cooling terminal interface group, a valve body assembly, a compressor, a condensation plate heat exchanger, and a dehumidification module, the compressor, the condensation plate heat exchanger, and the dehumidification module are arranged sequentially and at intervals in a width direction of the main frame, the dehumidification module is located between the compressor and the condensation plate heat exchanger, the external circulation compartment is configured to accommodate an outdoor heat exchanger and at least one heat exchange fan, the heat exchange fan is located above the outdoor heat exchanger in a height direction of the main frame, the liquid cooling terminal interface group is arranged on a side wall of the internal circulation compartment, the liquid cooling terminal interface group is further configured to be connected to a liquid cooling pipeline group, and the valve body assembly communicates with the compressor, the condensation plate heat exchanger, the dehumidification module, and the outdoor heat exchanger. The door-mounted liquid cooling unit is connected to a cabinet door by using the main frame, improving mounting convenience. This occupies small or no space of a cabinet body connected to the cabinet door, and improves space utilization of the cabinet body. In addition, the liquid cooling pipeline group is inserted into the liquid cooling terminal interface group through a liquid cooling pipeline group, so that the liquid cooling unit is conveniently connected to a to-be-heat-exchanged component, to improve convenience of the liquid cooling unit.

### BRIEF DESCRIPTION OF DRAWINGS

FIG. 1 is a diagram of a structure of an energy storage cabinet according to an embodiment of this application;
FIG. 2 is a diagram of air circulation of a liquid cooling unit in an energy storage cabinet according to an embodiment of this application;
FIG. 3 is a diagram of a structure of an energy storage cabinet according to an embodiment of this application;
FIG. 4 is a diagram of a structure of a liquid cooling unit according to an embodiment of this application;
FIG. 5 is a diagram of a structure of performing heat exchange on an energy storage cabinet by a liquid cooling unit according to an embodiment of this application;
FIG. 6 is a diagram of a structure of performing heat exchange and dehumidification on an energy storage cabinet by a liquid cooling unit according to an embodiment of this application;
FIG. 7 is a diagram of another structure of performing heat exchange on an energy storage cabinet by a liquid cooling unit according to an embodiment of this application;
FIG. 8a is a diagram of another structure of a liquid cooling unit according to an embodiment of this application; and
FIG. 8b is a main view of a first cover body in FIG. 8a.

### Reference numerals:

10: energy storage cabinet; 11: cabinet body; 12: cabinet door; 120: protective net; 13: battery pack; 14: power converter; 20: liquid cooling unit; 21: internal circulation compartment; 210: liquid cooling terminal interface group; 211: first side plate; 2110: first maintenance window; 2111: second maintenance window; 212: second side plate; 213: third side plate; 214: fourth side plate; 215: first cover plate; 2151: air inlet; 2152: air outlet; 216: second cover plate; 217: partition plate; 22: external circulation compartment; 30: hinge structure; 40: liquid cooling pipeline group; 50: air guide shutter; 60: filter screen; 101: electronic control apparatus; 102: valve body assembly; 103: compressor; 104: condensation plate heat exchanger; 1040: third heat exchange part; 1041: fourth heat exchange part; 105: evaporation plate heat exchanger; 1050: first heat exchange part; 1051: second heat exchange part; 106: dehumidification module; 1060: dehumidification evaporator; 1061: dehumidification fan; 107: first water pump; 108: second water pump; 109: integrated plate; 110: outdoor heat exchanger; 111: heat exchange fan; 112: first valve body; 113: second valve body.

### DESCRIPTION OF EMBODIMENTS

To make objectives, technical solutions, and advantages of this application clearer, the following further describes this application in detail with reference to accompanying drawings.

With continuous development of energy storage technologies, there are a plurality of apparatuses for energy storage, for example, a cabinet-type energy storage station or a container-type energy storage station. In a process of charging and discharging an energy storage battery in the cabinet-type energy storage station or the container-type energy storage station, a large amount of heat is generated, so that a temperature of the battery continuously increases.

To dissipate heat for energy storage batteries and power converters that are disposed in the cabinet-type energy storage station and the container-type energy storage station, liquid cooling units are disposed in both the cabinet-type energy storage station and the container-type energy storage station. However, the liquid cooling unit in the conventional technology occupies large space, and the liquid cooling unit in the conventional technology does not have a dehumidification function.

Therefore, how to reduce space occupied by the liquid cooling unit and enable the liquid cooling unit to have the dehumidification function becomes an urgent problem to be resolved.

Terms used in the following embodiments are merely intended to describe particular embodiments, but are not intended to limit this application. As used in this specification and appended claims of this application, singular expressions "one", "a", "the", "the foregoing", "this", and "the one" are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean reference to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

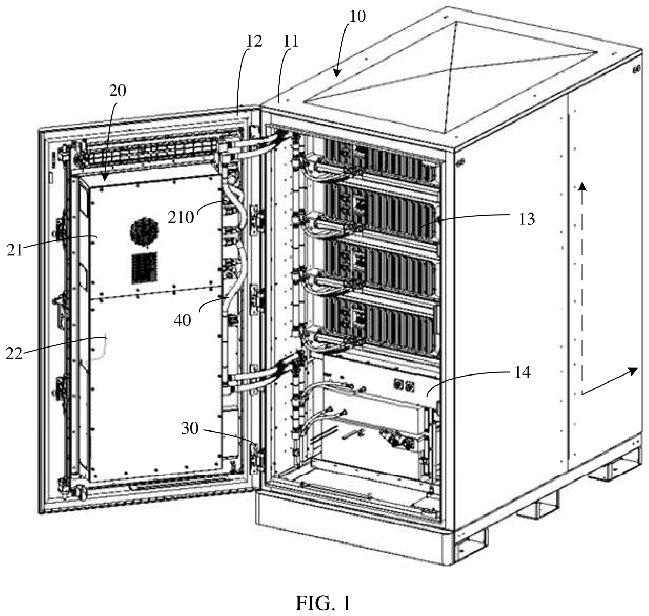

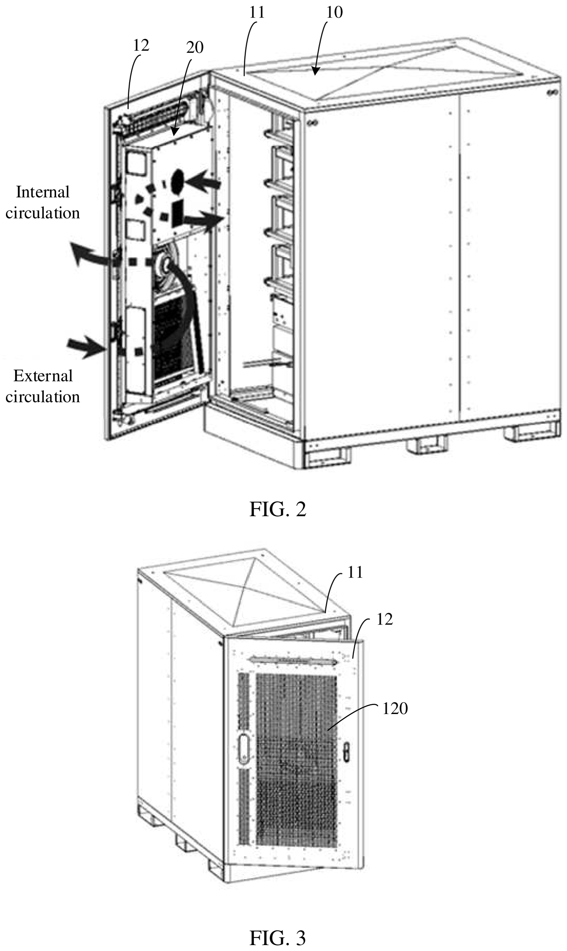

FIG. 1 is a diagram of a structure of an energy storage cabinet according to an embodiment of this application. FIG. 2 is a diagram of flow directions of air in an internal circulation compartment and an external circulation compartment in an energy storage cabinet according to an embodiment of this application. In FIG. 1, a direction of a dashed line arrow represents height directions of a cabinet body 11 and a cabinet door 12, and a direction of a solid line arrow represents width directions of the cabinet body 11 and the cabinet door 12. Refer to FIG. 1 and FIG. 2. The energy storage cabinet includes an energy storage cabinet 10 and a liquid cooling unit 20. The energy storage cabinet 10 is configured to accommodate the liquid cooling unit 20 and at least one of a battery pack 13 or a power converter 14. The energy storage cabinet 10 includes the cabinet body 11 and the cabinet door 12. The cabinet body 11 is configured to fasten the battery pack 13 or the power converter 14, and the cabinet door 12 is configured to close the cabinet body 11, to seal the battery pack 13 or the power converter 14 in the cabinet body 11, and prevent the battery pack 13 or the power converter 14 from being damaged due to pollution caused by an external environment to the battery pack 13 or the power converter 14. When the liquid cooling unit 20 is disposed, the liquid cooling unit is fastened on a side that is of the cabinet door 12 and that faces the battery pack 13 or the power converter 14. In this way, independent space for mounting the liquid cooling unit 20 does not need to be disposed in the cabinet body 11, so that the liquid cooling unit 20 occupies small space of the cabinet body 11, thereby increasing a capacity of the energy storage cabinet 10.

It should be noted that the cabinet body 11 accommodates the battery pack 13 or the power converter 14, or the cabinet body 11 accommodates the battery pack 13 and the power converter 14. The following uses an example in which the cabinet body includes the battery pack 13 and the power converter for description.

Still refer to FIG. 1 and FIG. 2. An internal circulation in FIG. 2 means a process in which air in the cabinet body 11 flows into an internal circulation compartment 21 and flows out of the internal circulation compartment 21. An external circulation means a process in which air outside the energy storage cabinet 10 flows into the external circulation compartment 22 and flows out of the external circulation compartment 22. In the height direction of the cabinet door 12, the liquid cooling unit 20 includes the internal circulation compartment 21 and the external circulation compartment 22, and the internal circulation compartment 21 is stacked on the external circulation compartment 22. The internal circulation compartment 21 and the external circulation compartment 22 are separated from each other. The internal circulation compartment 21 communicates with the cabinet body 11, so that the air in the cabinet body 11 enters the internal circulation compartment 21. The internal circulation compartment 21 dehumidifies the air that is in the cabinet body 11 and that enters the internal circulation compartment 21. The external circulation compartment 22 communicates with an outside of the energy storage cabinet 10, so that the external air exchanges heat with a component in the external circulation compartment 22. In addition, the internal circulation compartment 21 and the external circulation compartment 22 are separated from each other, so that components in the liquid cooling unit 20 are disposed in different regions for ease of maintenance, and the external air is prevented from entering an inside of the cabinet body 11, improving working stability of the battery pack 13 and the power converter 14 in the cabinet body 11.

Still refer to FIG. 1 and FIG. 2. The cabinet body 11 is connected to the cabinet door 12 in the width direction of the cabinet body 11 through a hinge structure 30, the internal circulation compartment 21 includes a liquid cooling terminal interface group 210, the liquid cooling terminal interface group 210 is arranged on a side that is of the internal circulation compartment 21 and that faces the hinge structure 30, the liquid cooling terminal interface group 210 is configured to communicate with at least one liquid cooling pipeline group 40, and the at least one liquid cooling pipeline group 40 is configured to dissipate heat for the battery pack 13 and the power converter 14. The liquid cooling pipeline group 40 is connected to the liquid cooling terminal interface group 210 in a quick-plug manner, so that the battery pack 13 and the power converter 14 are conveniently connected to the liquid cooling unit 20, and convenience of connecting the battery pack 13 and the power converter 14 to the liquid cooling unit 20 is improved.

FIG. 3 is a diagram of another structure of an energy storage cabinet according to an embodiment of this application. Refer to FIG. 1 and FIG. 3. To facilitate mounting of the liquid cooling unit 20 on the cabinet door 12, a mounting opening (not shown in the figure) is disposed on a side that is of the cabinet door 12 and that is away from the cabinet body 11, and the liquid cooling unit 20 is mounted on the mounting opening. To prevent an impurity from entering the external circulation compartment, a protective net 120 is mounted on the mounting opening.

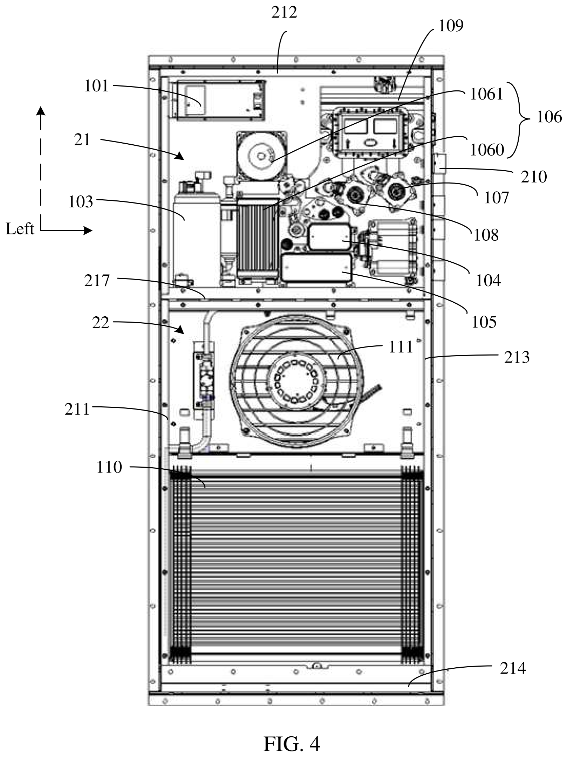

FIG. 4 is a diagram of a structure of a liquid cooling unit according to an embodiment of this application. Refer to FIG. 4. The internal circulation compartment 21 is further configured to accommodate an electronic control apparatus 101, a valve body assembly, a compressor 103, a condensation plate heat exchanger 104, an evaporation plate heat exchanger 105, a dehumidification module 106, a first water pump 107, and a second water pump 108. The electronic control apparatus 101 is electrically connected to the compressor 103, the valve body assembly, the dehumidification module 106, the first water pump 107, and the second water pump 108, and the valve body assembly 102 communicates with the liquid cooling terminal interface group 210, the compressor 103, the evaporation plate heat exchanger 105, the condensation plate heat exchanger 104, and the dehumidification module 106 separately. The condensation plate heat exchanger 104 provides a cold source for the dehumidification module 106. In this manner, the dehumidification module 106 dehumidifies the air in the cabinet body, the condensation plate heat exchanger 104 provides the cold source for the dehumidification module 106, and an independent cold source for serving the dehumidification module 106 is not needed. This can simplify a structure of the liquid cooling unit, and can further reduce costs of the liquid cooling unit.

The dehumidification module 106 includes a dehumidification evaporator 1060 and a dehumidification fan 1061.

In FIG. 4, the direction of the dashed line arrow represents the height direction of the cabinet door, and the direction of the solid line arrow represents the width direction of the cabinet door. Still refer to FIG. 1. In the height direction of the cabinet door, the compressor 103 and the electronic control apparatus 101 are disposed at an interval, the evaporation plate heat exchanger 105 and the condensation plate heat exchanger 104 are disposed at an interval, and the first water pump 107 and the second water pump 108 are located between the condensation plate heat exchanger 104 and a top of the internal circulation compartment. In the width direction of the cabinet door the compressor 103 and the condensation plate heat exchanger 104 are disposed at an interval, the dehumidification module 106 is disposed between the compressor 103 and the condensation plate heat exchanger 104, and the first water pump 107 and the second water pump 108 are disposed at an interval. The valve body assembly and the condensation plate heat exchanger 104 are disposed at an interval in a direction perpendicular to the height direction of the cabinet body and the width direction of the cabinet body. The compressor 103 is disposed at a bottom of the internal circulation compartment, the electronic control apparatus 101 is disposed at the top of the internal circulation compartment, and the compressor 103 and the electronic control apparatus 101 are located on a left side of the internal circulation compartment in the width direction of the cabinet body. This disposition manner can enable disposition of each component in the internal circulation compartment more compact.

Still refer to FIG. 4. The internal circulation compartment 21 further accommodates an integrated plate 109, the valve body assembly is disposed inside the integrated plate 109, and the first water pump 107, the second water pump 108, the evaporation plate heat exchanger 105, and the condensation plate heat exchanger 104 are all disposed on the integrated plate 109. In this way, each component is disposed in the internal circulation compartment more easily. In addition, the dehumidification module 106 may also be integrated on the integrated plate 109, to be specific, the dehumidification evaporator 1060 and the dehumidification fan 1061 are also disposed on the integrated plate 109.

Still refer to FIG. 4. The external circulation compartment 22 is configured to accommodate an outdoor heat exchanger 110 and at least one heat exchange fan 111, and the heat exchange fan 111 is disposed above the outdoor heat exchanger in the height direction of the cabinet door. The outdoor heat exchanger 110 is configured to exchange heat with the outside of the energy storage cabinet. The air outside the energy storage cabinet enters the external circulation compartment 22 through the outdoor heat exchanger 110, and flows out of the external circulation compartment through the heat exchange fan 111. The outdoor heat exchanger 110 communicates with the valve body assembly. A quantity of heat exchange fans 111 is disposed according to an actual requirement.

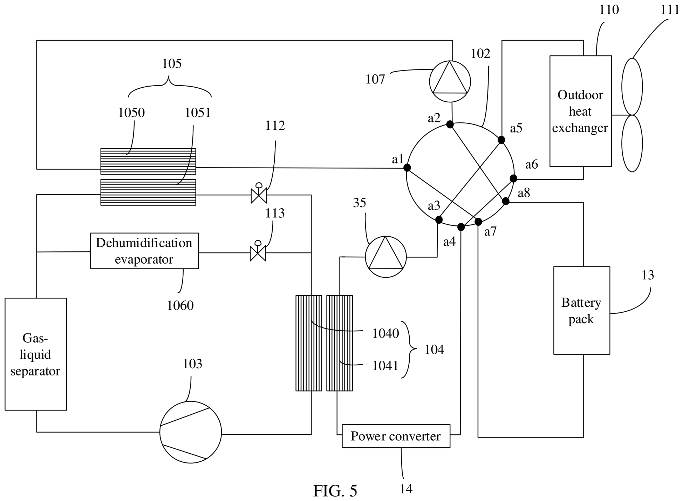

FIG. 5 is a diagram of a structure of performing heat exchange between a liquid cooling unit and a battery pack and a power converter in an energy storage cabinet according to an embodiment of this application. The evaporation plate heat exchanger 105 includes a first heat exchange part 1050 and a second heat exchange part 1051, and the condensation plate heat exchanger 104 includes a third heat exchange part 1040 and a fourth heat exchange part 1041. A first end of the first water pump 107 communicates with a second port a2 of the valve body assembly 102, a second end of the first water pump 107 communicates with a second end of the first heat exchange part 1050, a first end of the first heat exchange part 1050 communicates with a first end a1 of the valve body assembly 102, and the second heat exchange part 1051, the third heat exchange part 1040, and the compressor 103 are sequentially connected in series to form a closed loop. A first end of the second water pump 108 communicates with a third end a3 of the valve body assembly 102, a second end of the second water pump 108 communicates with a first end of the fourth heat exchange part 1041, a second end of the fourth heat exchange part 1041 communicates with a first end of the power converter 14, and a second end of the power converter 14 communicates with a fourth end a4 of the valve body assembly 102. A first end of the outdoor heat exchanger 110 communicates with a fifth end a5 of the valve body assembly 102, a second end of the outdoor heat exchanger 110 communicates with a sixth end a6 of the valve body assembly 102, and a seventh end a7 and an eighth end a8 of the valve body assembly 102 communicate with the battery pack 13.

Still refer to FIG. 5. The foregoing valve body assembly 102 has eight ports, in other words, the valve body assembly 102 is an eight-port valve. When the battery pack 13 and the power converter 14 need to be cooled, the electronic control apparatus controls the first end a1 to communicate with the seventh end a7, the second end a2 to communicate with the eighth end a8, the third end a3 to communicate with the fifth end a5, and the fourth end a4 to communicate with the sixth end a6 in the valve body assembly 102. The electronic control apparatus further controls the compressor 103 to operate. High-temperature and high-pressure air is exhausted from an exhaust vent of the compressor 103, and enters the third heat exchange part 1040. The high-temperature and high-pressure air through the third heat exchange part 1040 exchanges heat with the fourth heat exchange part 1041 to become a liquid refrigerant. In this process, a temperature of a refrigerant in the fourth heat exchange part 1041 increases. The liquid refrigerant formed by passing through the third heat exchange part 1040 enters the second heat exchange part 1051, absorbs heat in the first heat exchange part 1050, and vaporizes through the second heat exchange part 1051. In this process, a temperature of a refrigerant in the first heat exchange part 1050 decreases, a cooled refrigerant in the first heat exchange part 1050 flows to a liquid cooling end 130 through the valve body assembly 102, and the refrigerant flows to the battery pack 13 to take away heat generated by the battery pack 13, thereby avoiding an excessively high temperature in the energy storage cabinet. In addition, when a refrigerant with a rising temperature in the fourth heat exchange part 1041 passes through the power converter 14, the power converter 14 is cooled. The refrigerant passing through the power converter 14 enters the outdoor heat exchanger 110 for further cooling through the valve body assembly 102, and flows back to the fourth heat exchange part 1041 through the valve body assembly 102 under driving of the second water pump 108, to continue to absorb heat of the third heat exchange part 1040.

In the foregoing embodiment, the liquid cooling unit further includes a first valve body 112 and a second valve body 113. The first valve body 112 is disposed between the second heat exchange part 1051 and the third heat exchange part 1040. A dehumidification apparatus includes the dehumidification evaporator 1060 and the dehumidification fan. Two ends of the dehumidification evaporator 1060 communicate with the third heat exchange part 1040 and the compressor 103 respectively, that is, the dehumidification evaporator 1060 and the second heat exchange part 1051 are connected in parallel, and the second valve body 113 is disposed between the dehumidification evaporator 1060 and the third heat exchange part 1040. When dehumidification needs to be performed on the air in the energy storage cabinet, and the electronic control apparatus controls the compressor 103 to work and the second valve body 113 to be in an open state, the dehumidification fan sucks the air in the energy storage cabinet into the internal circulation compartment through an air inlet. When the dehumidification evaporator 1060 is specifically disposed, the dehumidification evaporator 1060 is disposed on a side close to the dehumidification fan, so that most air entering the internal circulation compartment needs to pass through the dehumidification evaporator 1060. The dehumidification evaporator 1060 communicates with a third heat exchange pipe group 370, and the liquefied low-temperature refrigerant in the third heat exchange part 1040 passes through the dehumidification evaporator 1060. In this way, the air passing through the dehumidification evaporator 1060 is cooled. When the air reaches a dew point temperature, water in the air may be precipitated into liquid water and flow into a condensate water pan of the liquid cooling unit, and then exhausted back to the energy storage cabinet, to achieve dehumidification.

It should be noted that, when dehumidification needs to be performed on the air in the energy storage cabinet, it is determined, based on humidity in the energy storage cabinet, to open or close the first valve body 112. Similarly, when the battery pack 13 and the power converter 14 are cooled, it is determined, based on a temperature of the air in the energy storage cabinet, to open or close the second valve body 113.

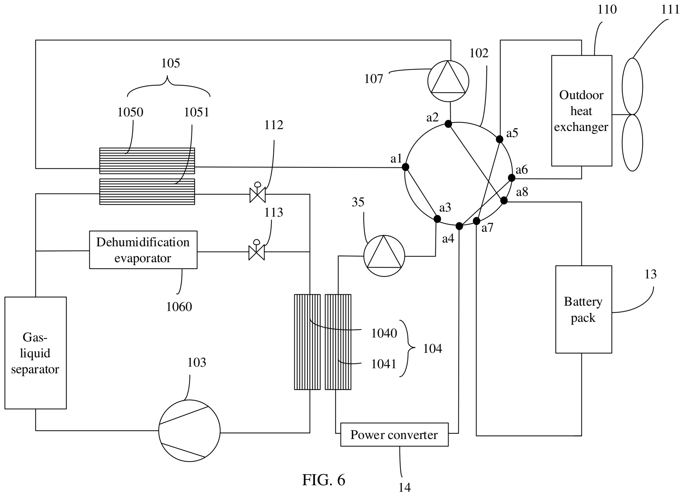

FIG. 6 is a diagram of another structure of a liquid cooling unit during working according to an embodiment of this application. Refer to FIG. 6. When the battery pack 13 and the power converter 14 need to be cooled, the electronic control apparatus further controls a first end a1 to communicate with a third end a3, a second end a2 to communicate with an eighth end a8, a fourth end a4 to communicate with a sixth end a6, and a fifth end a5 to communicate with a seventh end a7 in the valve body assembly 102. In this case, the electronic control apparatus further controls the compressor 103 not to work, and a refrigerant completes heat exchange with the air outside the energy storage cabinet through the outdoor heat exchanger 110, so that a temperature of the refrigerant decreases. A low-temperature refrigerant enters a liquid cooling end 130 through the fifth end a5 and the seventh end a7 of the valve body assembly 102, to cool an energy storage battery. After the refrigerant passing through the liquid cooling end 130 passes through the eighth end a8 and the second end a2 of the valve body assembly 102, the first water pump 107 and the first heat exchange part 1050, the refrigerant passes through the first end a1 and the third end a3 of the valve body assembly 102, and flows through the power converter 14 through the fourth heat exchange part 1041 under driving of the second water pump 108, to cool the power converter 14. The refrigerant passing through the power converter 14 flows back to the outdoor heat exchanger 110 through the fourth end a4 and the sixth end a6 of the valve body assembly 102, and exchanges heat with the air outside the energy storage cabinet through the outdoor heat exchanger 110. In this process, because the compressor 103 does not work, a first heat exchange part 1050 does not exchange heat with a second heat exchange part 1051, and a fourth heat exchange part 1041 does not exchange heat with a third heat exchange part 1040.

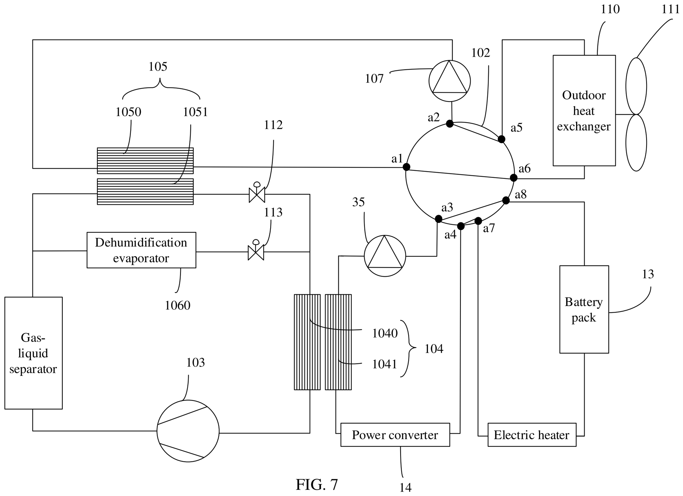

FIG. 7 is a diagram of another structure of a liquid cooling unit during working according to an embodiment of this application. Refer to FIG. 7. In a specific implementation process, an energy storage cabinet can alternatively be in a low-temperature environment, and the battery pack 13 and the power converter 14 need to be heated. In this case, the electronic control apparatus controls a first end a1 to communicate with a sixth end a6, a second end a2 to communicate with a fifth end a5, a third end a3 to communicate with an eighth end a8, and a fourth end a4 to communicate with a seventh end a7 in the valve body assembly 102. In addition, an electric heater is further disposed in the energy storage cabinet. The electric heater is connected between the seventh end a7 of the valve body assembly 102 and a liquid cooling end 130. The electric heater heats a refrigerant that enters the electric heater through the seventh end a7 of the valve body assembly 102. A heated refrigerant flows into the liquid cooling end 130 to heat an energy storage battery, and then flows through the second water pump 108 through the eighth end a8 of the valve body assembly 102 and the third end a3 of the valve body assembly 102. After the refrigerant passing through the second water pump 108 enters a fourth heat exchange part 1041, the refrigerant flows through the power converter 14, to heat the power converter 14, and the refrigerant passing through the power converter 14 flows back to the electric heater through the fourth end a4 and the seventh end a7 of the valve body assembly. In this process, heat exchange is not performed between the fourth heat exchange part 1041 and a third heat exchange part 1040, and the compressor 103 does not work.

Still refer to FIG. 7. When the energy storage battery and the power converter 14 are heated, the electric heater does not work, and the compressor 103 is controlled to work. High-temperature and high-pressure air is exhausted from an exhaust vent of the compressor 103, and enters the third heat exchange part 1040. The high-temperature and high-pressure air through the third heat exchange part 1040 exchanges heat with a fourth heat exchange pipe group 371 to become a liquid refrigerant. In this process, a temperature of a refrigerant in the fourth heat exchange part 1041 can increase, and a refrigerant with a rising temperature flows through the power converter 14, to heat the power converter 14. The refrigerant passing through the power converter 14 enters the liquid cooling end 130 through the fourth end a4 and the seventh end a7 of the valve body assembly 102, to heat the liquid cooling end 130. The refrigerant passing through the liquid cooling end 130 flows back to the fourth heat exchange part 1041 through the eighth end a8 and the third end a3 of the valve body assembly 102 under an action of the second water pump 108. The liquid refrigerant formed by passing through a third heat exchange pipe group 370 enters a second heat exchange part 1051, absorbs heat in a first heat exchange part 1050 and vaporizes through the second heat exchange part 1051. In this process, a temperature of a refrigerant in the first heat exchange part 1050 decreases, and a cooled refrigerant in the first heat exchange part 1050 flows to an outdoor heat exchanger 110 through the first water pump 107 and the second end a2 and the fifth end a5 of the valve body assembly 102, and exchanges heat with the air outside the energy storage cabinet through the outdoor heat exchanger 110, to cool the refrigerant. A cooled refrigerant flows back to the first heat exchange part 1050 through the sixth end a6 and the first end a1 of the valve body assembly 102.

In the foregoing embodiment, the liquid cooling unit further includes a gas-liquid separator. The gas-liquid separator separates the refrigerant that passes through the second heat exchange part 1051 into a gas refrigerant and a liquid refrigerant, and the gas refrigerant enters the compressor 103.

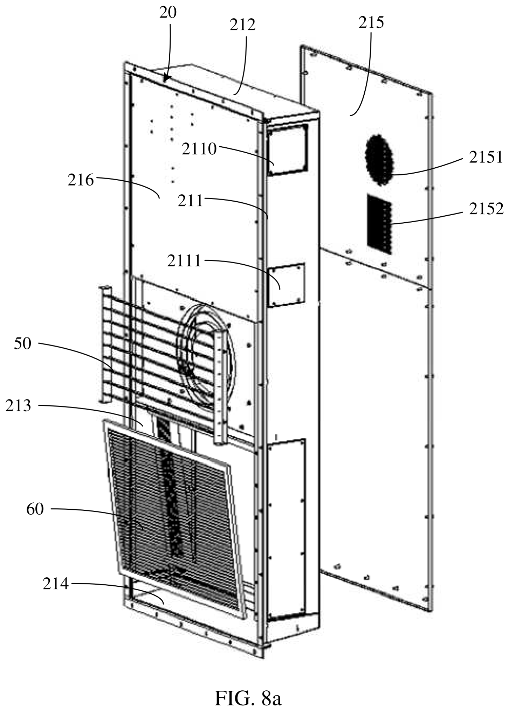

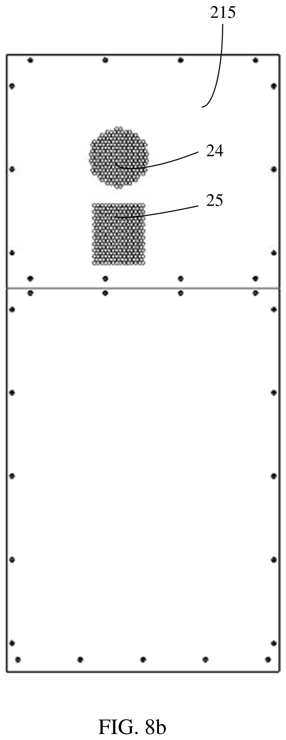

FIG. 8a is a diagram of another structure of a liquid cooling unit according to an embodiment of this application. FIG. 8b is a diagram of a structure of a first cover plate in FIG. 8a. Refer to FIG. 3, FIG. 4, FIG. 8a, and FIG. 8b. The liquid cooling unit 20 includes a main frame, a first cover plate 215, a second cover plate 216, and a partition plate 217. The main frame is mounted on the cabinet door. The main frame includes a first side plate 211, a second side plate 212, a third side plate 213, and a fourth side plate 214 that are sequentially connected head to tail. In the width direction of the cabinet door, one end of the partition plate 217 is connected to the first side plate 211, the other end of the partition plate 217 is connected to the third side plate 213, the partition plate 217 is disposed in parallel with the second side plate 212 and the fourth side plate 214. The first cover plate 215 is located on a side that is of the main frame and that faces the cabinet body, and the first cover plate 215 covers the side that is of the main frame and that faces the cabinet body. The second cover plate 216 is located on a side that is of the main frame and that faces the cabinet door, and the second cover plate 216 covers a part between the partition plate 217 and the second side plate 212. Specifically, the compressor 103 is mounted on a side that is of the partition plate 217 and that faces the second side plate 212, and the compressor 103 is close to the first side plate 211. The electronic control apparatus 101 is mounted on a side that is of the second side plate 212 and that faces the first side plate 211, and the electronic control apparatus 101 is close to the first side plate 211. The integrated plate 109 is connected to the partition plate 217 and the third side plate 213. The dehumidification module 106 is disposed between the integrated plate 109 and the compressor 103, the evaporation plate heat exchanger 105 and the condensation plate heat exchanger 104 are disposed at an interval in the height direction of the cabinet door, and the first water pump 107 and the second water pump 108 are disposed at an interval in the width direction of the cabinet door. In this disposition manner, integration of the component in the internal circulation compartment 21 is higher. It should be noted that, in the width direction of the cabinet door, the first side plate 211 is disposed on a left side, and the foregoing liquid cooling terminal interface group 210 is disposed on the third side plate 213. In addition, the partition plate 217, the first cover plate 215, the first side plate 211, the third side plate 213, and the fourth side plate 214 form the external circulation compartment, and the partition plate 217, the first cover plate 215, the second cover plate 216, the first side plate 211, the second side plate 212, and the third side plate 213 form the internal circulation compartment.

An air inlet 2151 and an air outlet 2152 are disposed on the first cover plate 215. The air inlet 2151 corresponds to the dehumidification fan, and the air outlet 2152 corresponds to the dehumidification evaporator. The dehumidification fan enables the air in the cabinet body to quickly enter the internal circulation compartment, and air exhausted through the air outlet is dehumidified by the dehumidification evaporator.

Still refer to FIG. 8a. The first side plate 211 is provided with a first opening and a second opening, the first opening and the second opening are located between the partition plate 217 and the second side plate 212, the first opening is provided on a side that is of the first side plate 211 and that is close to the second side plate 212, so that the first opening corresponds to the electronic control apparatus 101, and the second opening is provided on a side that is of the first side plate 211 and that is close to the partition plate 217, so that the second opening corresponds to the compressor 103. It should be noted that an openable and closable window is disposed on the first opening, to form a first maintenance window 2110, and an openable and closable window is also disposed on the second opening, to form a second maintenance window 2111. Disposition of the first maintenance window 2110 and the second maintenance window 2111 facilitates maintenance of the electronic control apparatus 101 and the compressor 103.

Still refer to FIG. 8a. The liquid cooling unit 20 further includes a filter screen 60 and an air guide shutter 50. Both the filter screen 60 and the air guide shutter 50 are detachably connected to the first side plate and the third side plate, to facilitate maintenance of the filter screen 60 and the air guide shutter 50. The filter screen corresponds to the outdoor heat exchanger, to prevent a large-granularity impurity from entering the outdoor heat exchanger. The air guide shutter 50 corresponds to the at least one heat exchange fan, to avoid exhausted air flowing back, which causes low heat exchange efficiency of the outdoor heat exchanger.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application should be subject to the protection scope of the claims.

## Claims

1. An energy storage cabinet with a door-mounted liquid cooling unit, wherein the energy storage cabinet comprises the liquid cooling unit, the energy storage cabinet is configured to accommodate the liquid cooling unit and at least one of a battery pack or a power converter, the energy storage cabinet comprises a cabinet body and a cabinet door, the cabinet door is configured to close the cabinet body, the cabinet body is configured to fasten the battery pack or the power converter, and the liquid cooling unit is fastened to a side that is of the cabinet door and that faces the battery pack or the power converter.

2. The energy storage cabinet according to claim 1, wherein the liquid cooling unit comprises an internal circulation compartment and an external circulation compartment, the internal circulation compartment is stacked on the external circulation compartment in a height direction of the cabinet door, the internal circulation compartment is separated from the external circulation compartment, the internal circulation compartment communicates with the cabinet body, and the external circulation compartment communicates with an outside of the energy storage cabinet.

3. The energy storage cabinet according to claim 2, wherein the cabinet door is connected to the cabinet body in a width direction of the cabinet door by using a hinge structure, the internal circulation compartment comprises a liquid cooling terminal interface group, the liquid cooling terminal interface group is arranged on a side that is of the internal circulation compartment and that faces the hinge structure, the liquid cooling terminal interface group is configured to communicate with at least one liquid cooling pipeline group, and the at least one liquid cooling pipeline group is configured to dissipate heat for the battery pack or the power converter.

4. The energy storage cabinet according to claim 2 or 3, wherein
the internal circulation compartment is configured to accommodate an electronic control apparatus, a valve body assembly, a compressor, a condensation plate heat exchanger, and a dehumidification module, the electronic control apparatus is electrically connected to the compressor, the valve body assembly, and the dehumidification module, the valve body assembly communicates with the liquid cooling terminal interface group, the compressor, the condensation plate heat exchanger, and the dehumidification module separately, and the condensation plate heat exchanger is configured to provide a cold source for the dehumidification module.

5. The energy storage cabinet according to claim 4, wherein the compressor and the electronic control apparatus are disposed at an interval in the height direction of the cabinet door, the compressor and the condensation plate heat exchanger are disposed at an interval in the width direction of the cabinet door, the dehumidification module is located between the compressor and the condensation plate heat exchanger, and the valve body assembly and the condensation plate heat exchanger are disposed at an interval in a direction perpendicular to a height direction of the cabinet body and a width direction of the cabinet body; and
the compressor is disposed at a bottom of the internal circulation compartment, the electronic control apparatus is disposed at a top of the internal circulation compartment, and the compressor and the electronic control apparatus are located on a left side of the internal circulation compartment in the width direction of the cabinet door.

6. The energy storage cabinet according to claim 5, wherein the internal circulation compartment comprises a first maintenance window and a second maintenance window, the first maintenance window and the second maintenance window are disposed at an interval in the height direction of the cabinet door, and the first maintenance window and the second maintenance window are disposed on a left side of the cabinet door in the width direction of the cabinet door.

7. The energy storage cabinet according to claim 2, wherein
the external circulation compartment is configured to accommodate an outdoor heat exchanger and at least one heat exchange fan, and the outdoor heat exchanger is configured to exchange heat with the outside of the energy storage cabinet.

8. The energy storage cabinet according to claim 7, wherein the heat exchange fan is disposed above the outdoor heat exchanger in the height direction of the cabinet door.

9. The energy storage cabinet according to any one of claims 2 to 8, wherein the external circulation compartment further comprises an air guide shutter and a filter screen, and the air guide shutter and the filter screen are disposed on a side that is of the external circulation compartment and that faces the cabinet door.

10. The energy storage cabinet according to any one of claims 1 to 9, wherein the liquid cooling unit comprises a main frame, a first cover plate, a second cover plate, and a partition plate, and the main frame is mounted on the cabinet door; and
the main frame comprises a first side plate, a second side plate, a third side plate, and a fourth side plate that are sequentially connected head to tail, one end of the partition plate is connected to the first side plate and the other end of the partition plate is connected to the third side plate in the width direction of the cabinet door, the first cover plate is located on a side that is of the main frame and that faces the cabinet body, the first cover plate covers the side that is of the main frame and that faces the cabinet body, the second cover plate is located on a side that is of the main frame and that faces the cabinet door, and the second cover plate covers a part between the partition plate and the second side plate.

11. The energy storage cabinet according to claim 10, wherein the first side plate is provided with a first opening and a second opening, the first opening and the second opening are located between the partition plate and the second side plate, the first opening is located on a side that is of the first side plate and that is close to the second side plate, and the second opening is located on a side that is of the first side plate and that is close to the partition plate.

12. The energy storage cabinet according to any one of claims 1 to 11, wherein a mounting opening is disposed on a side that is of the cabinet door and that is away from the cabinet body, the mounting opening is configured to mount the liquid cooling unit, and a protective net is disposed on the mounting opening.

13. The energy storage cabinet according to any one of claims 1 to 11, wherein the cabinet body comprises the battery pack and the power converter; and the battery pack is located above the power converter in the height direction of the cabinet body.

14. The energy storage cabinet according to claim 13, wherein when the cabinet door closes the cabinet body, the liquid cooling unit partially overlaps the cabinet body in a projection of a plane that is perpendicular to the height direction of the cabinet body.

15. A door-mounted liquid cooling unit, wherein the liquid cooling unit comprises a main frame, an internal circulation compartment, and an external circulation compartment;
the internal circulation compartment and the external circulation compartment are disposed on the main frame, and the internal circulation compartment and the external circulation compartment are separated from each other;
the internal circulation compartment is configured to accommodate a liquid cooling terminal interface group, a valve body assembly, a compressor, a condensation plate heat exchanger, and a dehumidification module;
the external circulation compartment is configured to accommodate an outdoor heat exchanger and at least one heat exchange fan; and
the liquid cooling terminal interface group is arranged on a side wall of the internal circulation compartment, the liquid cooling terminal interface group is further configured to be connected to a liquid cooling pipeline group, and the valve body assembly communicates with the compressor, the condensation plate heat exchanger, the dehumidification module, and the outdoor heat exchanger.
